Europäisches Patentamt

European Patent Office

Office européen des brevets

(11) Publication number: **0 186 635**
**A1**

## (12) EUROPEAN PATENT APPLICATION

(21) Application number: **85850329.5**

(22) Date of filing: **22.10.85**

(51) Int. Cl.⁴: **G 01 R 15/10**

(30) Priority: **26.10.84 FI 844219**

(43) Date of publication of application:
**02.07.86 Bulletin 86/27**

(84) Designated Contracting States:
**CH DE FR GB IT LI NL SE**

(71) Applicant: **VAISALA OY**
**Vanha Nurmijärventie 21**
**SF-00420 Helsinki(FI)**

(72) Inventor: **Lyyra, Matti**
**Kaivosrinteentie 1-3 F 50**
**SF-01610 Vantaa(FI)**

(74) Representative: **Lenz, Franz et al,**
**AWAPATENT AB Box 5117**
**S-200 71 Malmö(SE)**

(54) A method of measuring impedances, particularly low capacitances, by using one or more references.

(57) A method of measuring impedances, particularly low capacitances, in which method such measuring electronics is used which comprises one or more reference impedances, whose electrical ratings fall upon the measuring range. These refrence impedances are connected to a measuring circuit alternately with the impedance or impedances to be measured by a switch arrangement.

In order to take into account the individual non-linearities of the impedance sensor(s) $(C_e)$ and possibly to compensate variations of ambient circumstances such as temperature, the measuring circuit is equipped with a memory (10) for storing the individual characteristic curve(s) $y_e = f(x)$ of the sensor(s) and possibly the date arequired for the compensation.

The input signal $(D_{in})$ of said memory (10) are the binary sensor signals $(A_n \quad X_1,S_2..C_n)$ which define the memory addresses of said memory (10), and, the output signal $(D_{out})$ of said memory (10) are the values of the charasteric curve function $f(x_n)$ corresponding to each sensor signal $(X_n)$, said values containing the information about the quantity being measured.

The impedance sensor is used for measuring a changing physical quantity such as temperature, pressure, humidity, displacement, force and/or various types of radiation.

./...

FIG.5

A method of measuring impedances, particularly low capacitances, by using one or more references

The present invention relates to a method of measuring impedances, particularly low capacitances, in which method such measuring electronics is used which comprises one or more reference impedances, whose electrical ratings fall upon the measuring range. These reference impedances are connected to a measuring circuit alternately with the impedance or impedances to be measured by a switch arrangement.

More particularly, the invention relates to such impedance measuring methods in which the impedance is used as an electrical sensor used for measuring certain physical quantities.

In the prior art, there are various different impedance sensors whose operation is based on the fact that an impedance is dependent on the measured quantity, usually physical quantity, such as pressure, temperature, humidity, the position of the observed item, force, etc. Examples of such impedance sensors are strain gauges, resistors sensitive to pressure and/or temperature, and capacitances, whose ability to sense for instance pressure or temperature is based on the mutual position of the condenser plates, or whose ability to sense relative humidity is based on the variation of the dielectric constant of the capacitance. The manufacturing tolerances of the impedance sensors usually make the sensors individual, in other words they have an individual characteristic curve, i.e. an individual non-linearity and individual dependence on other parametres than the ones being measured, for instance temperature when pressure is being measured.

One basis for the present invention is the state of art described for instance in the Finnish patents Nos 54,664 and 57,319 of the inventor corresponding to United States patents Nos. 4,295,090 and 4,295,091, respectively. These patents describe a method for measuring low capacitances.

Capacitive sensors, whose capacitance depends upon the parameter to be measured, are used in radiosondes for measuring various parameters, particularly pressure, temperature and humidity. The capacitances of these sensors are often rather low, from a few picofarads to about twenty, thirty or forty, or, at the most, approximately a hundred picofarads. The measurement of low capacitandes entails problems due to, among other things, stray capacitances, variations of input voltage, and other interferences.

In the prior art, when measuring temperature, humidity, pressure, or other similar quantities with electrical or electromechanical sensors, one or more exactly known and stable references are installed in association with the measuring electronics, so that inaccuracies of the measuring circuit and/or sensor can be compensated.

It is a well-known method to use a reference capacitance in association with capacitive sensors so that the reference capacitance and the measured capacitance are alternately connected to a measuring circuit, usually to an input circuit that determines the frequency of an RC-oscillator. By suitably adjusting the measuring circuit, or in some other way, the output quantity of the measuring circuit deduced from the reference capacitance may at each time be set to a correct level.

A known method is to use one-reference measuring circuits, particularly bridge connections. In these methods, the measurement is accurate only if the electrical value of the reference is close to the value of the sensor, for example, when the bridge is in balance. The greater is the deviation between the value of the sensor and the reference, the greater are various errors, for example, errors due to variations in the dynamics of the electronic measuring circuit. An advantage of one-reference circuits is the simplicity of the measuring circuit and the calculations connected with it.

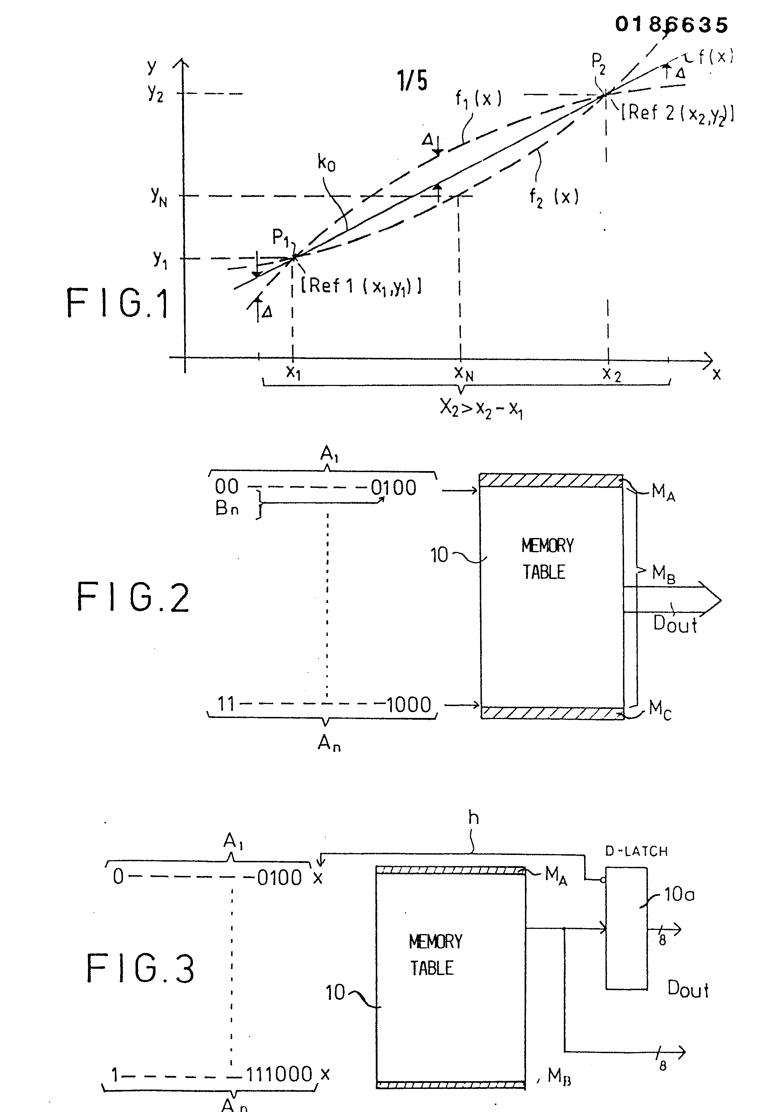

An advantage of two-reference or multi-reference measuring arrangements is the accuracy of measurement over a wide measuring range; a drawback is the complexity of design and calculation. Fundamental principles of two-reference measuring are more closely described below with reference to fig. 1.

An object of the present invention is to provide such a measuring circuit and method for measuring impedance in which the complex calculations formerly required for defining the results of the measurement are eliminated.

Another object of the invention is to provide a method of providing such a linearized and compensated sensor signal which can be coded to a suitable form and detected by direct indication without calculation, with the main emphasis on the reduction of the price of the circuit and on raising its speed.

In order to attain the aforedescribed objects and others hereinafter set forth, the principal charasteristic features of the invention are

that in order to take into account the individual non-linearities of the impedance sensor(s) and possibly to compensate variations of ambient circumstances such as temperature, the measuring circuit is equipped with a memory for storing the individual charasteristic curve(s) $y_e = f(x)$ of the sensor(s) and possibly the data required for the compensation,

that the input signal of said memory are the binary sensor signals which define the memory addresses of said memory, and

that the output signal of said memory are the values of the charasteric curve function $f(x_n)$ corresponding to each sensor signal, said values containing the information about the quantity being measured.

Within the framework of the invention, an accurate compensation and linearization can be carried out by microprocessor-based connections capable of calculation. Memories used in accordance with the invention are the most inexpensive and the fastest-developing components of said circuitry. The inventional idea is to tabulate the data relating to each sensor and required for the linearization and possibly for the compensation, to code it to a suitable form and store it in the memory, where the output quantity will be accessible directly, without calculation. Thus the price of the connection can be essentially reduced and its speed increased.

The invention will now be described in detail, with reference to the figures in the accompanying drawing, which illustrate the backround and some preferred embodiments of the invention.

Figure 1 illustrates in an x-y system of coordinates the characteristic curves of the two-reference measuring method.

Figure 2 illustrates one alternative application of the memory for undertaking the method of the invention.

Figure 3 illustrates the other alternative application of the memory for undertaking the method of the invention.

Figure 4A illustrates the use of the memory in a two-reference circuit for linearization and piecemeal compensation, i.e. the question is of the linear correction of a change of sensitivity.

Figure 4B illustrates a piecemeal linearization and compensation of a non-linear charasteristic curve in accordance with the invention.

Figure 5 is a block diagram of the first alternative overall embodiment of the invention.

Figure 6 is a block diagram of the second alternative overall embodiment of the invention.

Figure 1 illustrates a two-reference measuring method, which is one of the starting points of the invention. The method utilizes two references, reference 1 and reference 2, which fix two points in the x-y system of coordinates, points $x_1$ and $x_2$. The line $k_0$ running through these points is the linear basic function line of the system. In practice, due to for instance individual non-linearities of impedance sensors and changes in ambient circumstances, the charasteristic curves of the sensor vary on both sides of the line $k_0$, for instance between curves $f_1$ and $f_2$. Then it is possible to carry out measuring range $x_2 > x_2 - x_1$ within error limits $\Delta$.

When using one reference, which embodiment is also within the sphere of this invention, this reference fixes one point in the x-y system of coordinates, through which point the line characterizing the measuring system runs. By an one-reference circuit it is usually possible to carry out a measuring range smaller than the measuring range that can be carried out by two or more references as described above with reference to figure 1.

Reference 1 eliminates the transition error ($y_N = f(x)_N \pm \Delta x$) caused by the measuring circuit by locking the value corresponding to constant $x_1$ to $y_1$. Similarly, reference 2 eliminates the sensitivity error ($y_N = f(x)_N \pm k(x_n-x_1)$) by locking the y-value corresponding to constant $x_2$ to $y_2$.

By constants $x_1$, $x_2$ one makes the linear correction of errors caused by the measuring circuit. The errors of the measuring circuit are usually caused by variations of the ambient temperature, the loading of the circuit (stray capacitances), and the operating voltage.

The method in usually used in time-shared measuring, when the measuring sequence is $y_1$, $y_N$, $y_2$. From these quantities an auxiliary quantity $y'_N = (y_1 - y_N)/(y_1 - y_2)$ is calculated; as $y_1$ and $y_2$ are constants, a linear correction has been made to point $y_N$ located between them.

If the sensitivity of the sensor is high, i.e. $x_2 - x_1 \gg x_1$, more constants may be added to the circuit and a piecemeal linear correction may be done. Then it is possible to partially eliminate the non-linear change of sensitivity of the measuring circuit.

The measuring method corrects only errors caused by the measuring circuit. The overall accuracy is determined by the stability of the references, if the calibration and the operating situation remain the same. The unlinearity and the temperature-dependence of the sensor must be compensated by computation.

We shall now describe the backround and the main principles of the invention.

The charasteristic curve of a capacitive sensor is has often this form:

$$M(C_M) = A_0 C_M^0 + A_1 C_M^1 + A_2 C_M^2 + A_3 C_M^3 + A_4 C_M^4 + \ldots$$

The sensor is connected to an oscillator circuit, whose cycle time $T(c)$ is typically:

$$T(c) = k_0 + k_1 C + (k_2 C^2)$$

If the dynamics of the sensor

$$D = [C(M_{max}) - C(M_{min})]/C(M_{min})$$

is low, we can assume that the error caused by the measuring circuit can be described by a linear model, in which coefficients $k_0$ and $k_1$ may change from one measuring sequence to another, but not during one measuring sequence. By using two references $C_{k1}$ and $C_{k2}$ and by measuring the oscillator cycle times corresponding to capacitances $C_{k1}$, $C_M$, $C_{k2}$, we get

$$Y_M = (T_{k2} - T_M)/(T_{k2} - T_{k1}) =$$
$$(C_{k2} - C_M)/(C_{k2} - C_{k1}), \text{ whereupon}$$

$$C_M = C_{k2}(1 - Y_M) + Y_M C_{k1}$$

Usually $C_{k1} = 0$ pF, whereupon

$$C_M = C_{k2}(1 - Y_M).$$

The slow variation of coefficients $k_0$ and $k_1$ (time minutes) compared with the duration of the measuring sequence (approx. one second) is eliminated. The part of the non-linear term $k_2$ is virtually included in calibration coefficients $A_0$, $A_1$, ..., $A_4$. Its influence is small and, with sufficient accuracy, will remain the same in calibrating and operating situations.

A polynomial according to the model of each sensor is arranged through values C(M) obtained in the calibrating situation, and the coefficients $A_0$, $A_1$, ..., $A_n$ are produced. The corresponding values of M are calculated by means of these coefficients.

The procedure is based on the elimination of factors impairing the measuring accuracy by means of two references and calculation.

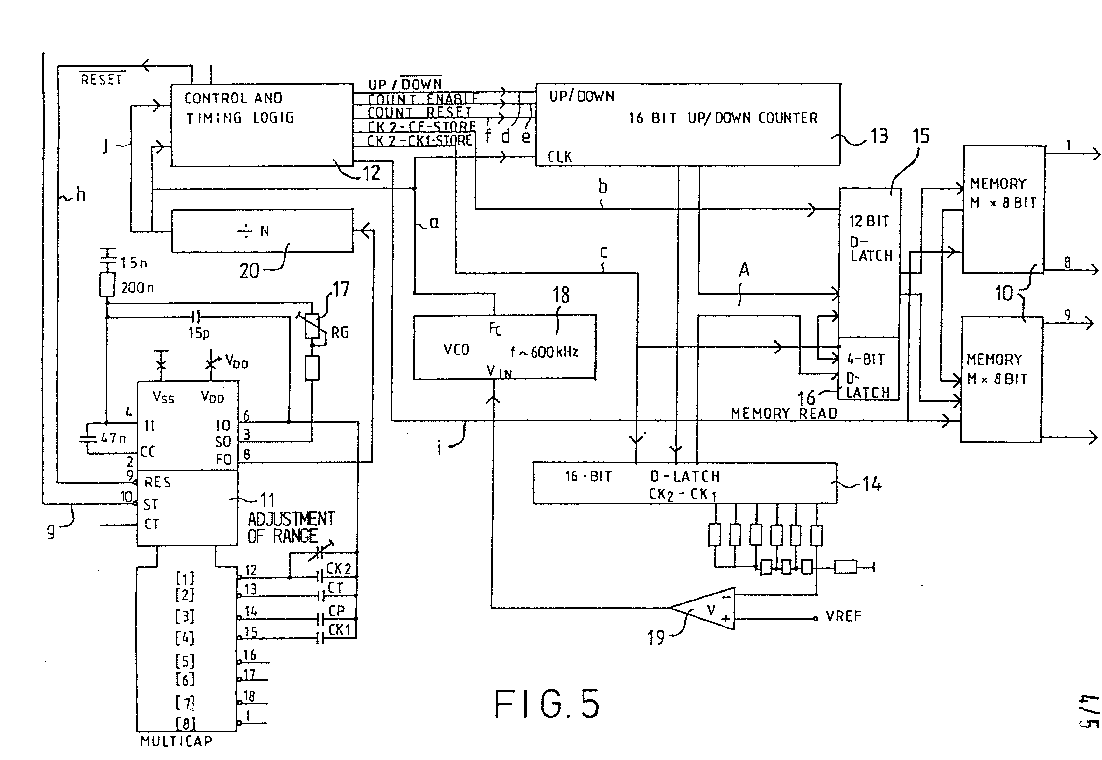

The measuring electronics shown in figure 5 comprises e.g. an RC-oscillator; each of capacitances $C_{k2}$, $C_E$, $C_{k2}'$ and $C_{k1}$ are alternately connected to an input circuit determining the its frequency. Said capacitances are usually between 0 and 100 pF. In accordance with figure 5, the nominator and denominator of the $y_e$ value determined above are measured by an auxiliary clock 18 and a binary up/down counter 13.

The circuit shown in figure 5 comprises the inventor's so called Multi-cap™ circuit 11, which is a patented special circuit particularly designed for measuring capacitive sensors. As to the design and operation of circuit 11, reference is made to said Finnish patents Nos. 57.664 and 57.319 corresponding to United States patents Nos. 4.295.090 and 4.295.091.

The measuring electronics comprise a divider 20 and a timer unit 12 connected with the Multicap™ circuit 11. The timer 12 provides control signals g = ST and h = RES required by the Multicap™ circuit 11, control signals d = UP/DOWN, e = COUNT ENABLE, F = COUNT RESET and LATCH required by the UP/DOWN COUNTER, and memory circuit control signals b = $C_{k2}$ − $C_E$ STORE, C = $C_{k2}'$ − $C_{k1}$ and i = MEMORY LOAD.

Operation of the circuit:

Description of the operation of the measuring sequence. Along line H, the timer unit gives to the Multicap™ circuit a RESET pulse, whereat the 1st sensor place is selected and simultaneously the counter is reset through line f and set to UP status through line d. The auxiliary clock ($V_{CO}$) 18 provides the clock function to both the timer and the counter. The counter is clocked upwards for the period $T_{k2} = N^{\cdot}(k^{\cdot}C_{k2} + \tilde{\tau})$, whereat the output of the divider 20 changes its status.

Now the number of pulses the counter contains is $BC_{k2} = T_{k2}{}^{\cdot}F_C$. By signal g, the timer directs the Multicap™ circuit to measure the sensor place being observed, and at the same time the counter is, by signal d, controlled to DOWN position, until the output j of the divider 20 again changes its status. Now the counter 13 is stopped by signal e = COUNT ENABLE, and it has counted downwards for the period TE = $N(k_E + \tilde{\tau})$. The contents of the counter is: $B(C_{k2} - C_E) = (T_{k2} - TE)^{\cdot}FC = N^{\cdot}K^{\cdot}(C_{k2} - C_E)^{\cdot}FC$ ($\tilde{\tau}$ is eliminated). The result is loaded by an impulse given by control signal b = $C_{k2}$ − CE STORE to a LATCH circuit 15 through a 16-bit bus A. 10 topmost signifying bits are loaded from the bus. After the loading has been accomplished, the timer resets the counter, steps to the next sensor place of the Multicap™ circuit, and releases the counter by signal e and sets it to the UP status by signal d.

After period $TC_{k2}' = N(kC_{k2} + \tau)$ the output of the divider N 20 changes again, and the contents of the counter will be $BC_{k2}' = T_{Ck2}'' FC$. The timer 12 stops the counter with signal e and steps the Multicap™ circuit 11 to the next sensor place $c_{k1}$, changes the counter to DOWN status d and permits counting e. After the period $TC_{k1} = N(kC_{k1} + \tau)$ the output j of the divider changes and the counter will be stopped by e. The result of the counter $B(C_{k2}' - C_{k1}) = N \cdot K \cdot (C_{k2}' - C_{k1}) \cdot FC$ is loaded, timed by line $C = C_{k2}' - C_{k1}'$, to a 16-bit D-LATCH 14 and to a D-LATCH 15 that controls the tree lowest memory bits. The output of LATCH 14 controls a 5-bit, resistor-net- and OP-amplifier-based D/A converter 19, whose output is 0, if the voltage supplied by the bit pattern = $U_{ref}$. The voltage difference is amplified (V) so that the created voltage circuit $V_{co}$ – counter – D/LATCH – D/A conversion N is subcritical, in other words maximum variation of 3 LSB is allowed in a 16 bit $B(C_{k2}' - D_{k1})$ word.

The timer zeroes the counter, resets the Multicap™ and restarts the sequence described above.

Controlled by the timer unit 12, the Multicap™ circuit 11 transmits frequency $F_C$

$$F_C^{-1} = K \cdot C + \tau$$

to the divider 20, whose output j changes at intervals of N impulses, whereat the inverval $T_C$ is

$$T_C = N \cdot (K \cdot C + \tau)$$

The output signal j of the divider 20 controls the timer 12, which controls the counter 13. Binary words $B(C_{k2} - CE)$ and $B(C_{k2}' - C_{k1})$, timed by the auxiliary clock $V_{CO}$, corresponding to time differences $TC_{k2} - TCE$

and $TC_{k2}' - TC_{k1}$, are received by the counter 13.

$$B(C_{k2} - CE) = N \cdot K \cdot (C_{k2} - CE) \cdot FC \qquad (1)$$

$$B(C_{k2}' - C_{k1}) = N \cdot K \cdot (C_{k2}' - CE) \cdot FC \qquad (2)$$

In formulae (1) and (2), K and FC depend on temperature, but in the same measuring sequence they remain the same, however. By holding the binary word of the equation 2 sufficiently constant by control circuit (D/LATCH 14, resistors, amplifier 19, $U_{ref}$, $V_{CO}$, counter) and by controlling the memory tables by the 3-bit LSB (LAST SIGNIFICANT BIT) section corresponding to the voltage difference, the temperature-dependence of K and FC can be eliminated.

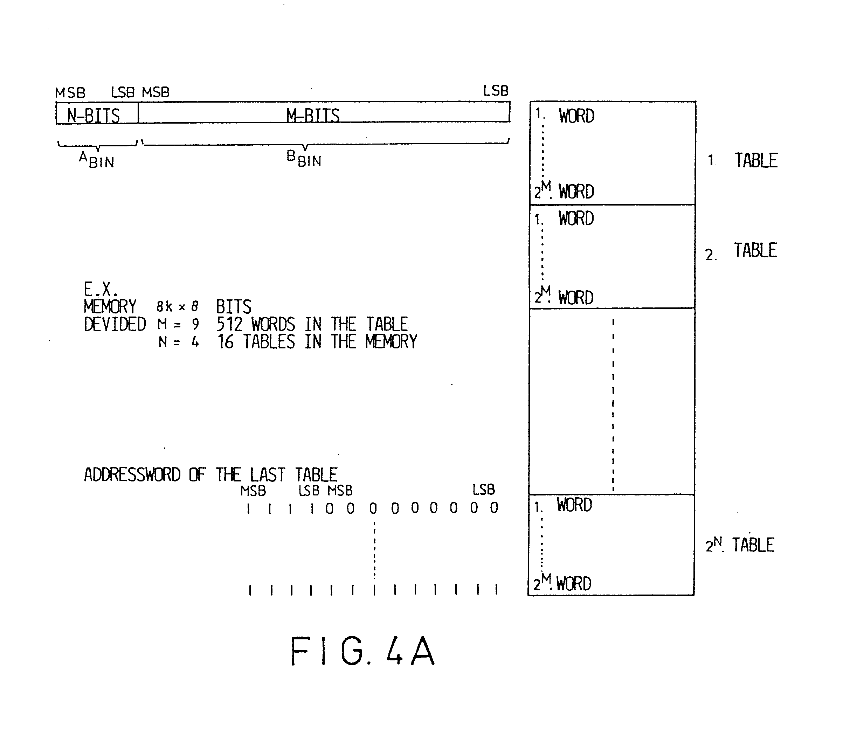

The resulting (1) binary word $B(C_{k2} - C_E)$ controls the contents of the table areas of the memory 10, and (2) binary word $B(C_{k2}' - C_{k1})$ selects the memory table (see figure 4A).

The used memory can be a normal UEPROM memory, which has an 8-bit output. By arranging two memories parallely and by controlling them by the same word, a 16-bit-resolution output can be created if required; one part of this output can be a sensor signal and the other part a calculated digital control signal.

The memory is programmed during the calibration. The sensitivity of the measuring circuit can be adjusted by resistor RG 17 in such a way that the control voltage g is in the half-way of its range.

OFFSET 20 of the sensor is adjusted by constant $C_{k2}$ so that

MSB                LSB

$B(C_{k2} - CE) = 0111111111$        when the sensor is in the half-way of its operation range

The sensor is adjusted to the reference conditions throughout its operation range (the quantity and the temperature to be compensated, for example pressure range (T = 25°C), pressure range (T = 40°C), ...). The to a computer, which calculates the linearized, scaled and suitably converted contents to the memory, which is controlled by said binary digit during operation.

The individual charasteristic curve(s) $y_e = f(x)$ of the used sensor or sensors and possibly the used measuring circuit have thus been stored in the memory at sufficiently short intervals $x = X_n - x_{n-1} = x_{n-1} - x_{n-2}$. The values of x, $x_n$, ..., $x_1$ define the addresses of the memory, each of which addresses contain values $y_e(x_n)$, ..., $y_e(x_1)$, which are received as the output signal $D_{out}$ of the memory. Earlier it was necessary to take the charasteristic curve into account with compex calculations. By means of a memory undertaking the method of the invention it is also possible to carry out the compensation of the measuring circuit in a fashion more closely described below. The code of signal $D_{out}$ can be programmed as desired (BIN, BCD, ...). A part of the bits of signal $D_{out}$ can be used for coding the limit values of the measuring signal.

More precise exemplary embodiments of the installment of the memory 10; 100 used in accordance with the invention will now be described with reference to figures 2, 3 and 4. In accordance with figure 2, the memory address $A_1$ of the memory 10 is a binary sensor signal produced as described above. The adjustment of the offset of the measuring circuit is located in bit $B_n$ in the beginning of the memory table of the memory 10. The end address $A_n$ of the memory table is adjusted by means of an adjustment of the amplification carried out by a rheostat 17 shown in fig. 5. The characteristic curve of the used impedance sensor, in this example the characteristics of the capacitance sensor and possibly of the electronics, are stored in the memory 10, so that a binary output signal $D_{out}$ described above will be produced. The memory 10 has unused areas $M_a$ and $M_c$, between which there is the memory table, in which said characteristic curve has been stored.

In accordance with fig. 3, $A_1$, ..., $A_n$ are binary sensor signals followed by control bit x indicated by h, produced by controller 10a, in such a way that when x = 0, the lowermost byte is directed to the D-latch 10a, and when x = 1, the uppermost byte is seen directly in the output.  The use of said control bit x and D-latch 10a can be avoided by using two parallel memory circuits.

In figure 4A, ABIN = the binary value of the quantity to be compensated. As the influence of the compensated quantity on the value being measured is usually low compared with the large range of the value being measured (e.g. the TC of a pressure sensor is typically ~ $\pm 0,04\%$ FSL/°C), it can be expressed with a considerably lower resolution.  The compensation is made piecemeal by tabulation.

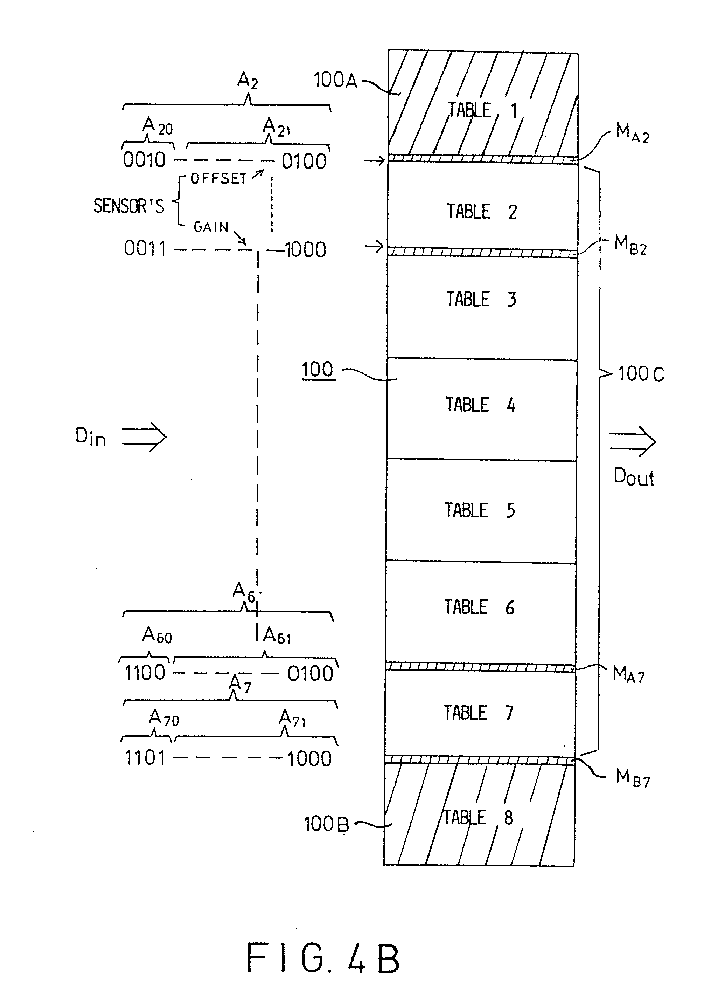

In fig. 4A, B BIN = the binary value of the quantity being measured. The measured range can be divided into $2^M$ words.  The length of the word can be 8 to 16 bits by connecting memory circuits parallely and by using one part of the word for the readout of for instance a linearized and coded measured value and the other part for the readout of a digital ON/OFF signal (e.g. a limit, an alarm, etc.).

In figure 4A the memory is programmed as follows:

In the calibration device the range and meaning of the measuring circuit are adjusted so that $0 < B_{bin} \leq 2^M$ and similarly $0 < A_{bin} < 2^N$ in all situations.  In fig. 4A the measuring circuit and the sensors are calibrated point by point in the desired reference circumstances, and based on these values (in the points in question), a linearized and coded value corresponding to each point is calculated and programmed into the memory.

Figures 4A and 4B show such a way to use the memory in accordance with the invention in which the compensation is carried out by means of the memory 100 (tables 1 to 8, figure 4A) divided into pieces.  Neither the top and bottom tables (table 1 and table 8), i.e. the sections 100A and 100B of the memory 100 nor the top or bottom sections $M_{A2}$, $M_{B2}$, ... of each table (tables 2 to 7) are not in use. The section of the memory 100 being in use (tables 2 to 7) is indicated by 100C. The binary signals $A_2$

to $A_7$ contain a binary signal $A_{20}$, ..., $A_{70}$ of the quantity being compensated, and after it, as described above, the binary sensor signal $A_{21}$, ..., $A_{71}$. The binary sensor signals $A_{21}$, ..., $A_{71}$ of the top sections of tables 2 to 7 contain information about the amplification of the measuring system, that is of the constant term (offset) and the slope of the characteristic curve $y_e = f(x)$. In figure 4, $D_{in}$ illustrates a bit flow, in other words the input signal of the memory 100, arriving to the memory 100 consisting of several pieces. By adjusting the zero-point of the quantity being compensated the binary word $A_{20}$, ..., $A_{70}$ is adjusted to a point in the middle of the table in the circumstances in question. In accordance with figure 4B, the memory 100 is therefore divided into several parallel tables (tables 2 to 7); each one of these tables corresponds to and will be used at a certain value of the quantity being compensated, i.e. the temperature.

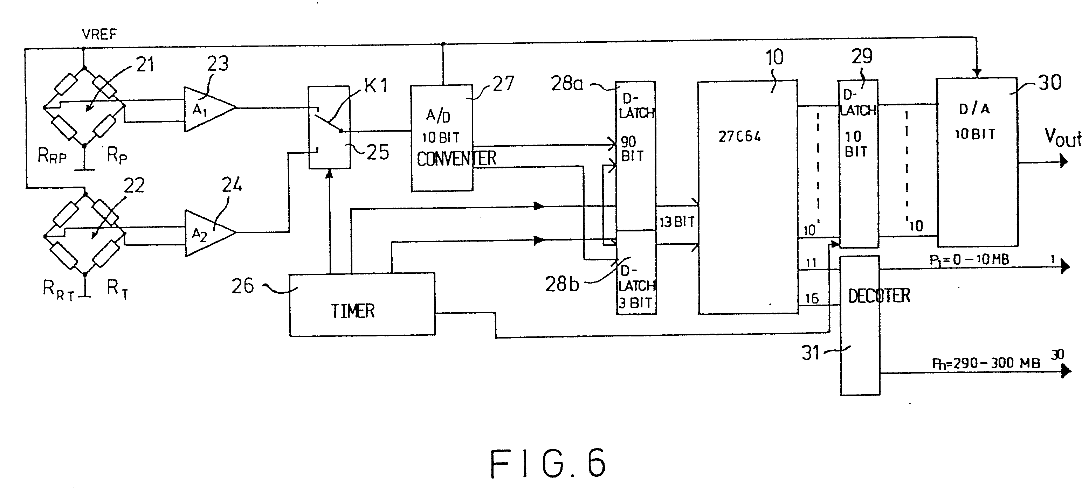

Figure 6 shows another embodiment undertaking the method of the invention. In this embodiment, the system comprises two bridge connections 21 and 22; one of them 21 comprises a resistor $R_p$, which functions as a pressure measuring sensor; the other one 22 comprises a resistor $R_T$, which functions as a temperature measuring sensor. The bridges 21 and 22 comprise reference resistors $R_{RP}$ and $R_{RT}$. The balance of the bridges 21 and 22 is observed by amplifiers 23 and 24, whose amplifications are indicated by $A_1$ and $A_2$. A switch $k_1$ in a unit 25 alternately connects to an A/D-converter (10-bit converter) 27 one bridge 21 and the other bridge 22. The function of the switching unit 25 and the circuits undertaking the method of the invention that follow the A/D-converter are controlled by a timer 26, which determines the measuring sequences. The pulse trains coming from the A/D converter 27 are connected to parallel for example 90-bit D-latch 28a and 3-bit D-latch 28b.

The units 28a and 28b are followed by the memory 10 conformable to the invention and operating as described above. The memory 10 is followed by a 10-bit D-latch 29 and thereafter a 10-bit D/A converter 30 providing a direct voltage $U_{out}$, which is linearized by means of the memory 10 used in accordance with the invention and contains information about the pressure and temperature measured by resistors $R_p$ and $R_T$. A decoder 31, providing pulse trains $p_1$ to $p_n$, is also connected to the memory 10.

The resolution of the circuit shown in fig. 6 is 10 bits. The circuit is linearized and temperature-compensated per each sensor by means of the memory 10 used in accordance with the invention.

The speed of a circuit in accordance with the invention can be defined by summing up the delays of the sensors, the conversion time of the A/D converter 27, the conversion time of the D/A converter 30, and the search time of the memory 10. The data regeneration time is determined by the speeds of the sensor and the measuring circuit. The search time of the memory 10 described above is approx. 400 ns. When using a Multi-cap™ circuit, said regeneration time is approx. 200 ms, which is mainly caused by the slowness of the frequency measurement.

The invention is by no means restricted to aforementioned details which are described only as examples; they may vary within the framework of the invention as defined in the following claims.

Claims

1. A method of measuring impedances, particularly low capacitances, in which method such measuring electronics is used which comprises one or more reference impedances, whose electrical ratings fall upon the measuring range, these reference impedances being connected to a measuring circuit alternately with the impedance or impedances to be measured by a switch arrangement, characterized in

that in order to take into account the individual non-linearities of the impedance sensor(s) ($C_e$) and possibly to compensate variations of ambient circumstances such as temperature, the measuring circuit is equipped with a memory (10; 100) for storing the individual charasteristic curve(s) $y_e = f(x)$ of the sensor(s) and possibly the data required for the compensation,

that the input signal ($D_{in}$) of said memory (10; 100) are the binary sensor signals ($A_n \sim C_1, X_2..C_n$) which define the memory addresses of said memory (10; 100), and

that the output signal ($D_{out}$) of said memory (10; 100) are the values of the charasteric curve function $f(x_n)$ corresponding to each sensor signal ($X_n$), said values containing the information about the quantity being measured.

2. A method as claimed in claim 1, characterized in that the impedance sensor is used for measuring a changing physical quantity such as temperature, pressure, humidity, displacement, force and/or various types of radiation.

3. A method as claimed in claims 1 or 2, characterized in that the method is applied in a two-reference measuring circuit and

that the characteristic curve of the measuring system has the form

$$y_e = (C_{k1} - C_e)/(C_{k2} - C_{k1})$$

where $C_{k1}$, $C_{k2}$ are the electrical values of two reference capacities or other similar impedances and $C_e$ is the electrical value of the capacitance being measured or another impedance,

that the numerator of $y_e$ is, after having been coded to a binary form, directly or via a latch (16, 28a, 28b) led to said memory (10) undertaking the method of the invention, to be the input signal ($D_{in}$) of said memory (10).

4. A method as claimed in one of claims 1 to 3, characterized in that the memory (100) is divided into several blocks, each block containing a stored measuring table (tables 2 to 7), each measuring table corresponding to a certain value of the quantity being compensated, for instance the temperature.

5. A method as claimed in claim 4, characterized in that the binary signals ($A_2$ to $A_7$) being led to said tables (tables 2 to 7) contain in binary form a signal ($A_{20}$ to $A_{70}$) about the quantity being compensated and a binary sensor signal ($A_{21}$ to $A_{71}$).

6. A method as claimed in one of claims 1 to 5, characterized in that from said memory (10; 100) binary signals are led via a holding circuit (29) or similar to a D/A converter (30), which provides an analog signal containing information about the quantity being measured.

7. A method as claimed in one of claims 1 to 6, characterized in that a part of the bits of the signal ($D_{out}$) provided by the memory (10; 100) in accordance with the invention is used for coding the limit values of the measuring signal.

8. A use of a method as claimed in one of claims 1 to 7 in radiosondes for telemetrical measurement of athmospheric pressure, temperature and/or humidity.

# FIG.1

1/5

# FIG.2

# FIG.3

MSB  LSB MSB                                      LSB

| N-BITS | M-BITS |

$A_{BIN}$        $B_{BIN}$

1. WORD
⋮
$2^M$. WORD          1. TABLE

1. WORD
⋮
$2^M$. WORD          2. TABLE

1. WORD
⋮
$2^N$. TABLE
$2^M$. WORD

E.X.
MEMORY  8k × 8  BITS
DEVIDED  M = 9  512 WORDS IN THE TABLE
              N = 4  16 TABLES IN THE MEMORY

ADDRESSWORD OF THE LAST TABLE

MSB        LSB MSB                    LSB

1  1  1  1  1  0  0  0  0  0  0  0  0  0  0

FIG. 4A

0186635

FIG. 4B

FIG.5

FIG. 6

| DOCUMENTS CONSIDERED TO BE RELEVANT | | | EP 85850329.5 |
|---|---|---|---|
| Category | Citation of document with indication, where appropriate, of relevant passages | Relevant to claim | CLASSIFICATION OF THE APPLICATION (Int. Cl.4) |
| X | <u>GB - A - 1 595 682</u> (ZUMBACH ELECTRONIC) <br> * Column 1, lines 37-44 * <br> ---- | 1 | G 01 R 15/10 |
| | | | **TECHNICAL FIELDS SEARCHED (Int. Cl.4)** |
| | | | G 01 R 15/00 <br> G 01 R 27/00 |
| The present search report has been drawn up for all claims | | | |

| Place of search | Date of completion of the search | Examiner |
|---|---|---|
| VIENNA | 27-03-1986 | KUNZE |